# EUROPÄISCHE PATENTSCHRIFT

(11) **EP 1 678 514 B1**
(45) Veröffentlichungstag und Bekanntmachung des Hinweises auf die Patenterteilung: **16.05.2007**
(21) Anmeldenummer: 05767980.5
(22) Anmeldetag: 11.07.2005
(51) Int. Cl.: G01R 31/36

(54) **BATTERIESENSOR UND VERFAHREN ZUM BETREIBEN EINES BATTERIESENSORS**
BATTERY SENSOR AND METHOD FOR OPERATION OF A BATTERY SENSOR
CAPTEUR DE BATTERIE ET PROCEDE DE FONCTIONNEMENT D'UN CAPTEUR DE BATTERIE

(30) Priorität: 13.07.2004 DE 102004033838
(43) Veröffentlichungstag der Anmeldung: 12.07.2006
(73) Patentinhaber: SIEMENS AKTIENGESELLSCHAFT, 80333 München (DE); Isabellenhütte Heusler GmbH & Co.KG, 35683 Dillenburg (DE)
(72) Erfinder: GRAF, Hans-Michael, 93049 Regensburg (DE); HETZLER, Ulrich, 35688 Dillenburg/Oberscheld (DE)
(86) Internationale Anmeldenummer: PCT/EP2005/053303
(87) Internationale Veröffentlichungsnummer: WO 2006/005739

(56) Entgegenhaltungen:
- DE-A1- 19 952 693
- US-A- 5 519 643
- US-A1- 2003 090 272

## Beschreibung

Die Erfindung betrifft einen Batteriesensor und ein Verfahren zum Betreiben eines Batteriesensors, der einen Strommesser, eine Auswerteeinheit und einen Mikroprozessor umfasst. Ein derartiger Batteriesensor wird insbesondere in einem Fahrzeug eingesetzt und ist geeignet zum Erfassen von Betriebsparametern einer Batterie, wie z.B. Strom, Spannung und Temperatur. Moderne Kraftfahrzeuge haben eine Vielzahl von elektrischen Verbrauchern, wie z.B. eine Vielzahl an Motoren für elektrische Fensterheber und zum Verstellen der Fahrzeugsitze. Ferner sind als elektrische Verbraucher häufig auch eine Fahrzeugheizung oder Sitzheizungen vorgesehen.

Aus der DE 199 52 693 A1 ist ein Verfahren und eine Vorrichtung zum Ermitteln, Anzeigen und/oder Auslesen des Zustands einer Batterie bekannt. Die Vorrichtung ist dazu ausgebildet, eine Batteriespannung, eine Batterietemperatur, einen Ladestrom, einen Entladestrom und einen Ruhestrom in gleichbleibenden oder dynamisch gewählten Intervallen zu erfassen. Die Vorrichtung hat eine Messvorrichtung zur Strommessung und umfasst ferner ein Microcontrollersystem, das einen AD-Wandler zum Analog-Digital-Wandeln der Messsignale hat. Das Microcontrollersystem hat einen Datenspeicher, in dem Kenndaten der Batterie gespeichert sind. Ferner werden in dem Microcontrollersystem die erfassten Messsignale weiter verarbeitet und so beispielsweise ein Ladezustand der Batterie ermittelt. Das Microcontrollersystem ist über einen Feldbus mit einer Steuerungsschnittstelle für die Bordelektronik gekoppelt, über die bei niedrigem Ladezustand eine Lastabschaltung von elektrischen Verbrauchern nach festgelegten Prioritäten erfolgen kann.

Für einen zuverlässigen Betrieb, insbesondere eines Fahrzeugs, ist es wichtig, dass auch nach einer Ruhephase, d.h. wenn die elektrischen Hauptverbraucher abgeschaltet sind, die Hauptverbraucher auch wieder zuverlässig in Betrieb genommen werden können.

Aus der DE 689 25 585 B2 ist eine Vorrichtung zum Entpassivieren einer passivierten Lithiumbatterie bekannt, die ein erstes Mittel umfasst zur als augenblicksweise bezeichneten kurzzeitigen Stromentnahme aus der passivierten Batterie, um deren Entpassivierung zu bewirken. Ein zweites Mittel ist vorgesehen zum Überwachen des Leistungsabgabezustands der Batterie und zum Steuern des ersten Mittels zur augenblicksweise Stromentnahme aus der passivierten Batterie, bis die Batterie in einen brauchbaren Leistungsabgabezustand zurückgekehrt ist.

Aus der WO 00/62087 A1 ist eine Konsumentennutzvorrichtung bekannt mit einem Körper der eine mechanische Anordnung zum Festmachen an einer Konsumentenvorrichtung und einer Batterie der Konsumentenvorrichtung hat. Der Körper nimmt eine elektronische Aufzeichnungsvorrichtung auf, die ausgebildet ist zum Erfassen einer Spannung und/oder eines Stroms der Batterie. In einem Aufzeichnungsmodus ist der Mikroprozessor in einem Ruhezustand. Periodisch wird der Mikroprozessor angeschaltet um Messungen durchzuführen. Abhängig von diesen Messungen kann ein Mikrocontroller bestimmen, ob die Vorrichtung sich weiterhin in dem gleichen Betriebsmodus befindet. Falls dies der Fall ist wird sie wieder in ihren Ruhezustand versetzt.

Aus der Veröffentlichung "Stromsparen - gewusst wie! - Tips zur Reduzierung von Batterieströmen in Mixed-Signal-Controller-Designs", Burkhardt, M., Elektronik 22/1999, Seiten 118 bis 124, ist offenbart, dass aktuelle Mikrocontroller eine Reihe von Funktionen bieten, die die Stromaufnahme in dem inaktiven Modus senken. In einem Sleep-Modus werden große Teile eines Controllers von der Stromversorgung abgekoppelt. Ferner sind schaltungstechnische Maßnahmen offenbart, die die Entladeströme der Batterie reduzieren.

Die Aufgabe der Erfindung ist es, einen Batteriesensor und ein Verfahren zum Betreiben eines Batteriesensors zu schaffen, das einen zuverlässigen Betrieb einer Batterie ermöglicht.

Die Aufgabe wird gelöst durch die Merkmale der unabhängigen Ansprüche. Vorteilhafte Ausgestaltungen der Erfindung sind in den Unteransprüchen gekennzeichnet.

Die Erfindung zeichnet sich aus durch ein Verfahren zum Betreiben eines Batteriesensors und einen entsprechend ausgebildeten Batteriesensor. Der Batteriesensor umfasst einen Strommesser zum Erfassen des Stroms der Batterie, eine Auswerteeinheit und einen Mikroprozessor. Während einer Ruhephase, in der elektrische Hauptverbraucher abgeschaltet sind, die einer Batterie zugeordnet sind, werden folgende Schritte durchgeführt. Der Mikroprozessor wird in einen abgeschalteten Zustand gesteuert. Auf diese Weise ist die elektrische Leistungsaufnahme des Mikroprozessors auf einen minimalen Wert reduziert. In vorgegebenen ersten Zeitabständen wird durch die Auswerteeinheit das Messsignal des Strommessers für eine vorgebbare erste Zeitdauer erfasst und diesem erste Stromwerte zugeordnet, die in der Auswerteeinheit auf das Überschreiten eines ersten Stromschwellenwertes und/oder das Unterschreiten eines zweiten Stromschwellenwertes überwacht werden. Bei Überschreiten bzw. Unterschreiten der Stromschwellenwerte wird die Mikroprozessoreinheit in einen eingeschalteten Zustand versetzt und für eine vorgegebene zweite Zeitdauer wird das Messsignal des Strommessers durch die Auswerteeinheit erfasst und ihm zweite Stromwerte zugeordnet, die dann in dem Mikroprozessor ausgewertet werden. Vorgegebene Maßnahmen zum Erhalten der elektrischen Ladung der Batterie werden durch den Mikroprozessor veranlasst, wenn eine vorgegebene Bedingung erfüllt ist, die abhängt von den während der zweiten Dauer erfassten Stromwerten. Die erste Zeitdauer ist kleiner als die zweite Zeitdauer. Die erste und zweite Zeitdauer unterscheiden sich bevorzugt mindestens um eine Größenordnung. Die während der ersten Zeitdauer erfassten Stromwerte sind weniger präzise als die während der zweiten Zeitdauer erfassten Stromwerte, da sich gezeigt hat, dass die Strommessung häufig mit einem Gaußschen Rauschen überlagert ist, das bei einer kurzzeitigen Strommessung zu einem großen Messfehler oder einem größeren Messfehler führt als bei einer länger andauernden Messung. Durch eine geeignete Wahl der Stromschwellenwerte, die besonders vorteilhaft abhängen können von zuletzt für die zweite Zeitdauer erfassten Stromwerten, kann mit einem geringen Messaufwand und somit auch einem geringen elektrischen Energieaufwand, sichergestellt werden, dass eine starke Veränderung des Stroms ausreichend schnell erkannt wird. Ein daraufhin erfolgendes Erfassen der Stromwerte für die zweite Zeitdauer liefert dann ein sehr präzises Messergebnis und kann eingesetzt werden, um präzise den Ladezustand der Batterie abzuschätzen und gegebenenfalls entsprechende Maßnahmen zum Erhalten der Ladung der Batterie zu veranlassen.

In einer vorteilhaften Ausgestaltung der Erfindung wird während der Ruhephase in vorgegebenen zweiten Zeitabständen der Mikroprozessor in den eingeschalteten Zustand versetzt und für die vorgegebene zweite Zeitdauer das Messsignal des Strommessers in der Auswerteeinheit erfasst und diesem zweite Stromwerte zugeordnet, die dann in dem Mikroprozessor ausgewertet werden. Die zweiten Zeitabstände sind größer gewählt als die ersten Zeitabstände, bevorzugt mindestens eine Größenordnung größer.

Dadurch kann einfach sichergestellt werden, dass auch während der Ruhephase regelmäßig, d.h. entsprechend der zweiten Zeitabstände, Stromwerte präzise erfasst werden und für eine Ermittlung des aktuellen Ladezustands der Batterie herangezogen werden können. Dennoch ist durch die geeignet große Wahl der zweiten Zeitabstände gewährleistet, dass die Batterie durch das Strommessen nur gering belastet ist bezogen auf die gesamte Ruhephase.

Es ist ferner vorteilhaft, wenn ein Integral des Stroms über die Zeitdauer der Ruhephase abhängig von den zweiten Stromwerten ermittelt wird. Abhängig von diesem Integral lässt sich leicht auf den Ladezustand der Batterie schließen.

In einer weiteren vorteilhaften Ausgestaltung der Erfindung wird ein Wecksignal für ein übergeordnetes Steuergerät erzeugt, das Maßnahmen für die Ladungserhaltung der Batterie durchführen kann, wenn das Integral des Stroms einen vorgegebenen Integral-Schwellenwert überschreitet. So ist dann einerseits sichergestellt, dass das übergeordnete Steuergerät während der Ruhephase für die meiste Zeit in seinem abgeschalteten Zustand ist und somit keine oder nur eine minimale elektrische Leistung aufnimmt und andererseits das übergeordnete Steuergerät dann wieder in seinen angeschalteten Zustand durch das Wecksignal versetzt wird und es Maßnahmen zur Ladungserhaltung der Batterie durchführen kann. Diese Maßnahmen können beispielsweise in einem Abschalten weiterer Verbraucher liegen, die auch während der Ruhephase grundsätzlich in einem angeschalteten Zustand sind.

Gemäß einer weiteren vorteilhaften Ausgestaltung der Erfindung umfasst der Batteriesensor einen Spannungsteiler, der eingangsseitig mit der an der Batterie abfallenden Spannung beaufschlagt ist und der ausgangsseitig mit einem Eingang der Auswerteeinheit elektrisch leitend verbunden ist. In Serie zu dem Spannungsteiler ist ein erster Schalter angeordnet, der in einer Schaltstellung einen Stromfluss durch den Spannungsteiler'unterbindet und in einer anderen Schaltstellung einen Stromfluss durch den Spannungsteiler ermöglicht. Der erste Schalter wird in der Ruhephase in die Schaltstellung gesteuert, in der er den Stromfluss durch den Spannungsteiler unterbindet. Dadurch wird einfach vermieden, dass in der Ruhephase ständig ein Strom durch den Spannungsteiler fließt, der von der Batterie zur Verfügung gestellt werden muss.

Gemäß einer weiteren vorteilhaften Ausgestaltung der Erfindung ist elektrisch parallel zu dem Spannungsteiler ein niederohmiger Widerstand angeordnet, zu dem elektrisch in Serie ein zweiter Schalter angeordnet ist, der in einer Schaltstellung einen Stromfluss durch den niederohmigen Widerstand unterbindet und in einer anderen Schaltstellung den Stromfluss durch den niederohmigen Widerstand ermöglicht. Der zweite Schalter wird in die Schaltstellung gebracht, in der er den Stromfluss durch den Spannungsteiler unterbindet. Anschließend wird die ausgangsseitige Spannung des Spannungsteilers als erster Spannungswert erfasst. Der zweite Schalter wird in die Schaltstellung gebracht, in der er den Stromfluss durch den Spannungsteiler ermöglicht und anschließend die ausgangsseitige Spannung des Spannungsteilers als zweiter Spannungswert erfasst. Abhängig von den ersten und zweiten Spannungswerten wird ein Leitungswiderstand einer elektrisch leitenden Verbindung zwischen der Batterie und dem Spannungsteiler ermittelt. Auf diese Weise kann einfach der Leitungswiderstand ermittelt werden. Mittels des Leitungswiderstands können die durch den Spannungsteiler ausgangsseitig erfassten Spannungswerte korrigiert werden. Es kann so ein präzises Erfassen der Spannung, die über der Batterie abfällt, gewährleistet werden. Diese Verfahrensschritte oder ein entsprechend geeignet ausgebildeter Batteriesensor setzen nicht notwendigerweise einen Strommesser und entsprechende Schritte zum Erfassen des Stroms voraus. Darüber hinaus ist es auch nicht notwendig, dass dem Spannungsteiler der erste Schalter zugeordnet ist.

Gemäß einer weiteren vorteilhaften Ausgestaltung der Erfindung umfasst die Batterie mindestens eine erste und eine zweite Batterie. Die erste und zweite Batterie sind elektrisch in Serie angeordnet. Ein Spannungsmesser zum Erfassen der Spannung, die entweder an der ersten oder der zweiten Batterie abfällt, ist vorgesehen. In der Auswerteeinheit werden Messwerte des Spannungsmessers in vorgegebenen dritten Zeitabständen erfasst und Messwerte der Ausgangsspannung des Spannungsteilers, die die an der ersten und zweiten Batterie abfallende Spannung repräsentieren, werden in vorgegebenen vierten Zeitabständen erfasst. Die dritten Zeitabstände sind größer als die vierten Zeitabstände. So kann einfach zum einen der Ladezustand der ersten Batterie als auch der zweiten Batterie ermittelt werden. Ferner hat es sich als ausreichend erwiesen, wenn die Spannung, die entweder an der ersten oder zweiten Batterie abfällt, weniger häufig erfasst wird als die Spannung, die sowohl an der ersten als auch der zweiten Batterie abfällt und es kann dennoch eine sehr präzise Aussage über den Ladezustand der jeweiligen Batterie getroffen werden. Die dritten Zeitabstände sind bevorzugt mindestens um eine Größenordnung größer als die vierten Zeitabstände.

Auch diese vorteilhafte Ausgestaltung kann auch unabhängig davon, ob der Batteriesensor einen Strommesser umfasst, vorteilhaft eingesetzt werden.

In einer weiteren vorteilhaften Ausgestaltung der Erfindung ist der Batterie ein Generator elektrisch parallel zugeordnet und ein weiterer Spannungsmesser ist zum Erfassen der Spannung, die an dem Generator abfällt, vorgesehen. Messwerte des weiteren Spannungsmessers werden in vorgegebenen fünften Zeitabständen erfasst in der Auswerteeinheit und Messwerte der Ausgangsspannung des Spannungsteilers werden in den vorgegebenen vierten Zeitabständen erfasst. Die fünften Zeitabstände sind größer als die vierten Zeitabstände, bevorzugt mindestens eine Größenordnung.

So kann einfach der Zustand des Generators als auch der Batterie ermittelt werden. Ferner hat es sich als ausreichend erwiesen, wenn die Spannung, die an dem Generator abfällt, weniger häufig erfasst wird als die Spannung, die an der Batterie abfällt und es kann dennoch eine sehr präzise Aussage über den Zustand des Generators getroffen werden.

Auch diese vorteilhafte Ausgestaltung kann auch unabhängig davon, ob der Batteriesensor einen Strommesser umfasst, vorteilhaft eingesetzt werden.

In einer weiteren vorteilhaften Ausgestaltung der Erfindung werden bei einem Unterschreiten eines vorgegebenen Spannungsschwellenwertes vorgegebene Betriebsparameter der Batterie erfasst und nichtflüchtig gespeichert. Dies kann z.B. in einem EEPROM erfolgen und dann nach einer späteren Überschreitung des vorgegebenen Spannungsschwellenwertes ausgewertet werden. So ist einfach eine Diagnose des Grundes für das Unterschreiten des Spannungsschwellenwertes möglich.

Auch diese vorteilhafte Ausgestaltung kann auch unabhängig davon, ob der Batteriesensor einen Strommesser umfasst, vorteilhaft eingesetzt werden.

Ausführungsbeispiele der Erfindung sind im Folgenden anhand der schematischen Zeichnungen näher erläutert. Es zeigen:
- Figur 1: eine erste Ausführungsform eines Batteriesensors,
- Figur 2: eine zweite Ausführungsform des Batteriesensors,
- Figur 3: ein Ablaufdiagramm eines Strommessvorgangs in dem Batteriesensor,
- Figur 4: ein Ablaufdiagramm für einen Betrieb eines Spannungsteilers des Batteriesensors,
- Figur 5: ein Programm zum Ermitteln eines Leitungswiderstandes,
- Figur 6: ein Ablaufdiagramm eines Programms zum Erfassen verschiedener Spannungswerte,
- Figur 7: ein weiteres Ablaufdiagramm eines weiteren Programms zum Erfassen verschiedener Spannungswerte und
- Figur 8: ein Ablaufdiagramm zum Überwachen eines Spannungsabfalls an der Batterie mittels des Batteriesensors.

Elemente gleicher Konstruktion oder Funktion sind figurenübergreifend mit den gleichen Bezugszeichen gekennzeichnet.

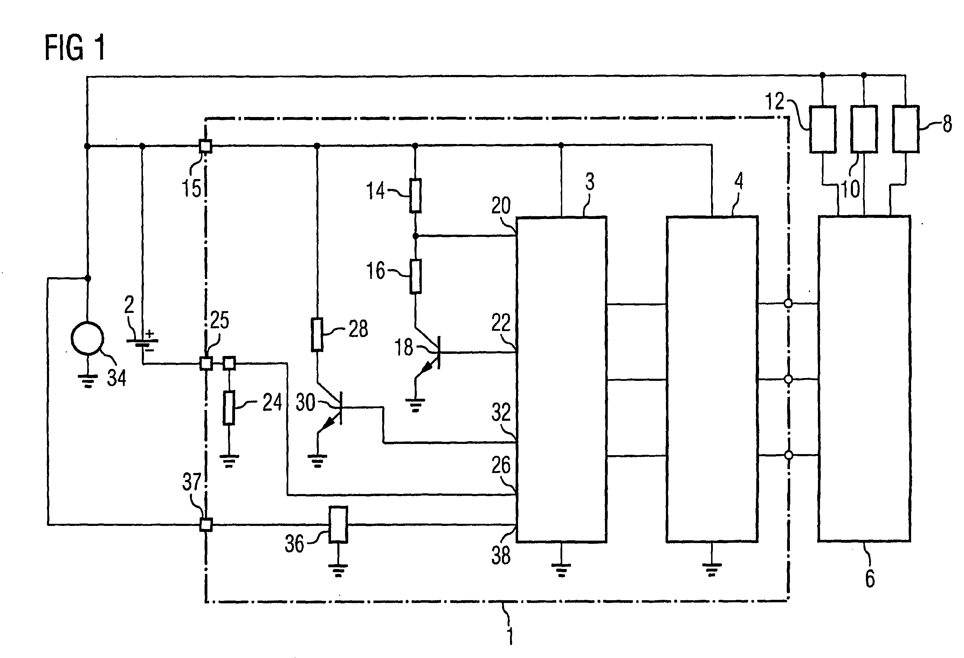

Ein Batteriesensor 1 (Figur 1) ist ausgebildet zum Erfassen, Auswerten und Überwachen verschiedener Betriebsparameter einer Batterie 2. Die Batterie 2 ist bevorzugt eine Fahrzeugbatterie, die in einem Fahrzeug, insbesondere einem Kraftfahrzeug, angeordnet ist und an ihrem Pluspol eine Versorgungsspannung bezogen auf ein Bezugspotential zur Verfügung stellt. Die Versorgungsspannung kann beispielsweise 12, 14, 24, 28, 36 oder 48 oder eine andere Volt-Anzahl betragen.

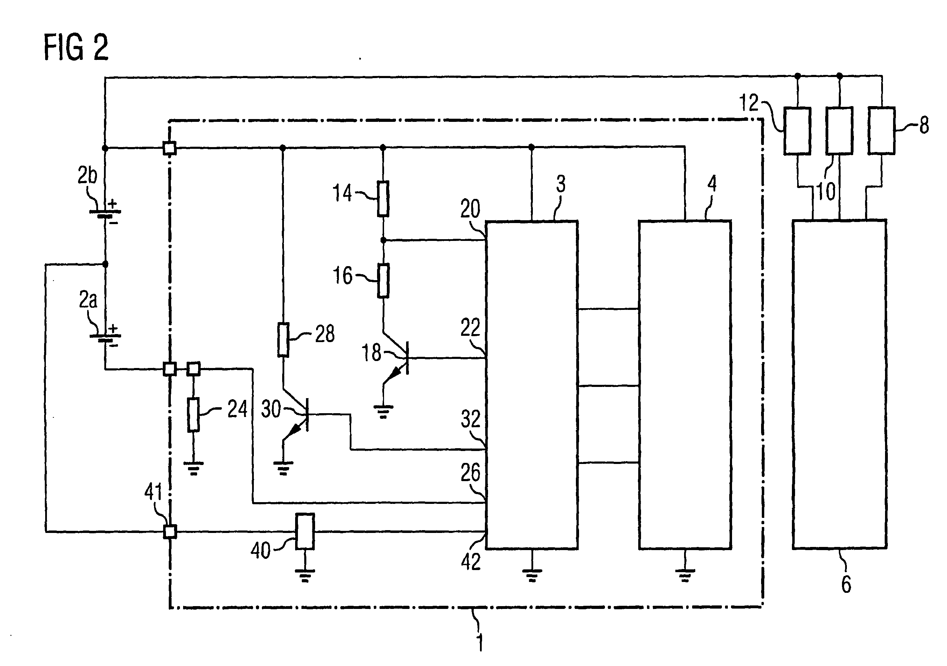

Der Batteriesensor umfasst ferner eine Auswerteeinheit 3, die bevorzugt ein ASIC ist mit mehreren Eingängen 20, 26, 38 (Figur 1), 42 (Figur 2), mit mehreren Ausgängen 22, 32, mindestens einem Analog-Digital-Wandler, bevorzugt einem integrierten Temperatursensor und mindestens einem Rechenmittel, das beispielsweise geeignet ist zum Durchführen einer digitalen Filterung der digital gewandelten Signale, die an einem der Eingänge anliegen oder einer sonstigen, regelmäßigen einfachen, weiteren Auswertung der digital gewandelten Signale. Sie kann ferner auch einen kleinen Speicher zum Zwischenspeichern von Daten umfassen. Die Auswerteeinheit 3 verfügt ferner über eine Kommunikationsschnittstelle zu einem Mikroprozessor 4, mit dem sie über entsprechende Signalleitungen elektrisch leitend verbunden ist. Der Mikroprozessor 4 verfügt über einen deutlichgrößeren Speicher als die Auswerteeinheit 3 zum Speichern von Daten und über mindestens ein Rechenmittel, das bevorzugt in der Lage ist, deutlich komplexere Rechenoperationen durchzuführen als es mit der Auswerteeinheit 3 möglich ist.

Der Batteriesensor 1 ist bevorzugt einer übergeordneten Steuereinheit 6 zugeordnet, mit der er über eine Schnittstelle, die in dem Mikroprozessor 4 ausgebildet ist, kommunizieren kann. Das übergeordnete Steuergerät 6 ist beispielsweise ein Fahrzeug-Bordnetz-Steuergerät, das verschiedene elektrische Verbraucher und insbesondere elektrische Hauptverbraucher 8, 10, 12 steuert. Die Verbraucher können beispielsweise Stellmotoren zum Verstellen der Fahrzeug-Sitzpositionen, eine Fahrzeugheizung, eine Sitzheizung, ein Steuergerät zum Steuern eines oder mehrer Airbags, ein Motorsteuergerät oder auch Stellantriebe für Stellglieder einer Brennkraftmaschine sein.

Das übergeordnete Steuergerät 6 kann somit ein Bordnetzsteuergerät sein, es kann jedoch gegebenenfalls auch eine Motorsteuerung oder ein anderes Steuergerät sein. Auf jeden Fall ist das übergeordnete Steuergerät 6 dazu ausgebildet, die Verbraucher entweder direkt oder auch indirekt durch entsprechende Befehle an ein anderes Steuergerät an- oder abzuschalten.

Der Batteriesensor 1 umfasst einen Spannungsteiler, der eingangsseitig mit einem Eingang 15 des Batteriesensors 1 elektrisch leitend verbunden ist. Der Eingang 15 des Batteriesensors 1 ist mit dem Pluspol der Batterie 2 elektrisch leitend verbunden. Der Spannungsteiler umfasst einen ersten Widerstand 14 und einen zweiten Widerstand 16, die elektrisch in Serie geschaltet sind. Ferner ist elektrisch in Serie zu dem ersten und zweiten Widerstand 14, 16 ein Schalter 18 angeordnet, der bevorzugt als Transistor ausgebildet ist. Ein Knotenpunkt in der elektrisch leitenden Verbindung zwischen dem ersten und zweiten Widerstand 14, 16 ist elektrisch leitend verbunden mit dem ersten Eingang 20 der Auswerteeinheit. Ein erster Ausgang 22 ist elektrisch leitend mit dem ersten Schalter 18 derart verbunden, dass der erste Schalter 18 abhängig von dem an dem ersten Ausgang 22 anliegenden Spannungspotential durch den ersten Schalter 18 einen Stromfluss durch den ersten und zweiten Widerstand 14, 16 ermöglicht oder unterbindet.

Ferner hat der Batteriesensor 1 einen Strommesser, der einen Stromznesswiderstand 24 umfasst, der auch als Shunt-Widerstand bezeichnet werden kann. Der Strommesswiderstand 24 ist stark niederohmig ausgebildet und kann beispielsweise einen Widerstandswert von etwa 100 µΩ haben. Der Strommesswiderstand ist einerseits mit einem Bezugspotential elektrisch leitend verbunden und andererseits elektrisch leitend mit einem Minuspol der Batterie 2 verbunden und zwar über einen Eingang 25 des Batteriesensors 1. Ein zweiter Eingang 26 der Auswerteeinheit 3 ist derart elektrisch leitend mit dem Strommesswiderstand 24 verbunden, dass an dem zweiten Eingang die an dem Strommesswiderstand 24 abfallende Spannung anliegt, die ein Maß für den Strom durch den Strommesswiderstand ist.

Elektrisch parallel zu dem Spannungsteiler ist ein dritter Widerstand 28 angeordnet, zu dem elektrisch seriell ein zweiter Schalter 30 angeordnet ist. Der dritte Widerstand ist niederohmig ausgebildet und weist z.B. einen Widerstandswert von 600 Ω auf. Der zweite Schalter ist ebenso wie der erste Schalter 18 bevorzugt als Transistor ausgebildet. An seinem Steuereingang ist der zweite Schalter 30 elektrisch leitend mit einem zweiten Ausgang 32 der Auswerteeinheit 3 verbunden. Abhängig von dem an dem zweiten Ausgang 32 anliegenden Spannungspotential unterbindet oder ermöglicht der zweite Schalter 30 einen Stromfluss durch den dritten Widerstand 28.

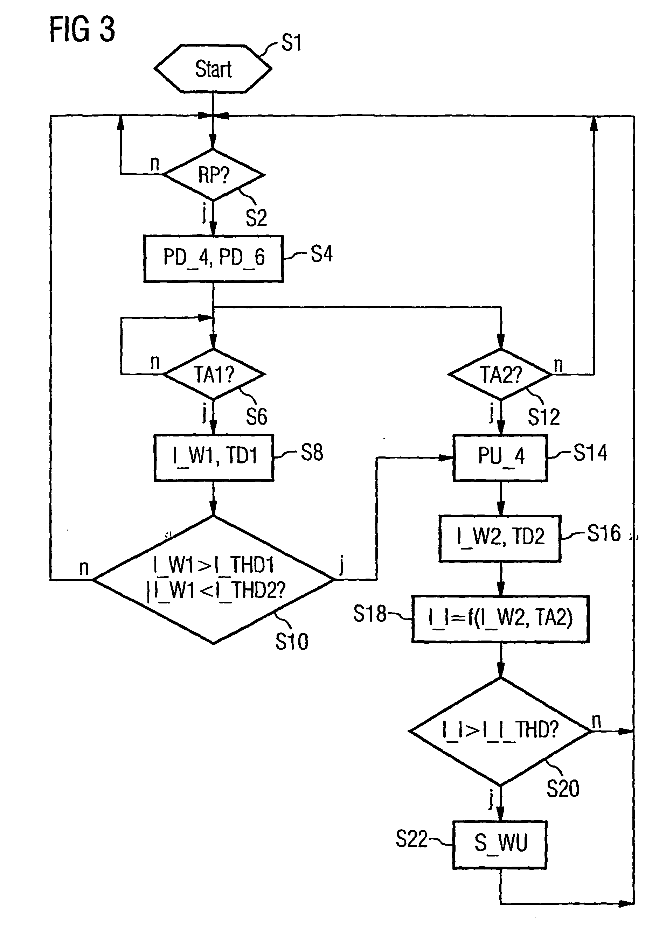

Ferner umfasst bevorzugt der Batteriesensor 1 einen Spannungsmesser 36, der über einen Eingang 37 mit einem Generator 34 derart elektrisch leitend verbunden ist, dass er die an dem Generator 34 abfallende Spannung erfassen kann. Der Span nungsmesser 36 ist elektrisch leitend mit einem dritten Eingang 38 der Auswerteeinheit 3 verbunden. Das Betreiben des Batteriesensors 1 ist weiter unten anhand der Ablaufdiagramme der Figuren 3 bis 8 näher erläutert.

Eine zweite Ausführungsform des Batteriesensors 1 (Figur 2) unterscheidet sich von der ersten Ausführungsform des Batteriesensors dadurch, dass die Batterie eine erste Batterie 2a und eine zweite Batterie 2b umfasst. Sie kann jedoch auch noch weitere Batterien umfassen. Dies ist beispielsweise häufig bei Lastkraftwagen der Fall, mit einem 24 V Bordnetz. Ein Eingang 41 des Batteriesensors 1 ist elektrisch leitend mit einem Knotenpunkt zwischen den beiden elektrisch in Serie geschalteten Batterien 2a, 2b verbindbar. Ein weiterer Spannungsmesser 40 ist elektrisch leitend mit dem Eingang 41 des Batteriesensors 1 verbunden. Der weitere Spannungsmesser 40 ist ferner ausgangsseitig mit einem vierten Eingang 42 der Auswerteeinheit 3 elektrisch leitend verbunden. Mittels des Spannungsmessers 40 kann so das zwischen der ersten und zweiten Batterie 2a, 2b anliegende Spannungspotential bezogen auf das Bezugspotential erfasst werden und dann der Auswerteeinheit 3 an ihrem vierten Ausgang 42 zur Verfügung gestellt werden.

Der Batteriesensor 1 gemäß der zweiten Ausführungsform kann auch den Eingang 37 und den weiteren Spannungsmesser 36 und den dritten Eingang 38 der Auswerteeinheit 3 gemäß der ersten Ausführungsform umfassen. Die Eingänge 20, 26, 42, 38 der Auswerteeinheit 3 sind bevorzugt über einen Multiplexer und Verstärker dem AD-Wandler der Auswerteeinheit zugeführt, der die an ihm anliegenden Signale analog/digital wandelt und dann zur weiteren Verarbeitung dem Rechenmittel der Auswerteeinheit 3 zur Verfügung stellt.

Der Strommesser kann auch einen Tiefpass-Filter umfassen, der dem dritten Eingang 26 vorgeschaltet ist und dessen Zeitkonstante bevorzugt abhängig davon einstellbar ist, ob eine Ruhephase RP vorliegt oder nicht. So kann die Zeitkonstante während der Ruhephase beispielsweise 3 s betragen und außerhalb der Ruhephase 3 ms betragen. Ebenso kann auch dem Spannungsteiler, der durch die ersten und zweiten Widerstände gebildet ist ein Tiefpassfilter zugeordnet sein. Ferner können auch den Spannungsmessern 36,40 entsprechende Tiefpassfilter zugeordnet sein. Der Spannungsteiler und die Spannungsmesser 36,40 können auch in die Auswerteeinheit 3 integriert sein.

Die Betriebsweise des Batteriesensors ist im Folgenden anhand der Ablaufdiagramme der Figuren 3 bis 8 näher erläutert. Die in den Ablaufdiagrammen dargestellten Abläufe können in der Auswerteeinheit 3 ablaufen, sie können jedoch auch zum Teil in dem Mikroprozessor 4 ablaufen.

Ein Programm für eine Strommessung wird in einem Schritt S1 (Figur 3) gestartet, in dem gegebenenfalls Variablen initialisiert werden. In einem Schritt S2 wird geprüft, ob gerade die Ruhephase RP vorliegt, die dadurch gekennzeichnet ist, dass die elektrischen Hauptverbraucher 8, 10, 12 bevorzugt abgeschaltet sind. Dies kann beispielsweise der Fall sein, wenn ein Kraftfahrzeug abgestellt ist und der Zündschlüssel abgezogen ist. Ist die Bedingung des Schrittes S2 nicht erfüllt, so wird sie, bevorzugt nach einer vorgebbaren Wartezeitdauer erneut in dem Schritt S2 geprüft. Ist die Bedingung des Schrittes S2 hingegen erfüllt, so werden in einem Schritt S4 der Mikroprozessor 4 und das übergeordnete Steuergerät 6 in ihre Abschaltzustände PD_4, PD_6 gesteuert. In dem Abschaltzustand PD_4, PD_6 nehmen der Mikroprozessor 4 und das übergeordnete Steuergerät 6 keine oder nur eine minimale elektrische Leistung auf.

In einem Schritt S6 wird geprüft, ob ein Schritt S8 letztmalig vor einem vorgegebenen ersten Zeitabstand TA1 bearbeitet wurde. Ist dies nicht der Fall, so wird die Bedingung des Schrittes S6 erneut nach der vorgegebenen Wartezeitdauer überprüft. Ist die Bedingung des Schrittes S6 hingegen erfüllt, so werden in dem Schritt S8 für eine vorgegebene erste Zeitdauer TD1 erste Stromwerte I_W1 erfasst. Dies erfolgt durch entsprechendes Analog-Digital-Wandeln der an dem zweiten Eingang des der Auswerteeinheit anliegenden Spannungen und entsprechendes Umrechnen abhängig von dem Widerstandswert des Strommesswiderstands 24 in die ersten Stromwerte. Die erste Zeitdauer beträgt beispielsweise in etwa 10 ms. Der erste Zeitabstand TA1 beträgt beispielsweise in etwa 1 Sekunde. Bevorzugt werden die ersten Strommesswerte I_W1 gefiltert, so z.B. gemittelt und dann der weiteren Bearbeitung zugrunde gelegt. Aufgrund der kurzen Messzeitdauer, also der ersten Zeitdauer TD1 wirkt sich ein Gaußsches Rauschen stark auf die Güte der erste Stromwerte I_N1 aus, die somit nur grob den tatsächlichen Wert des Stroms durch die Batterie 2 repräsentieren.

In einem Schritt S10 wird anschließend geprüft, ob die ersten Stromwerte I_W1 größer sind als ein erster Stromschwellenwert I_THD1 und/oder ob die ersten Stromwerte I_N1 kleiner sind als ein zweiter Stromschwellenwert I THD2. Die ersten und zweiten Stromschwellenwerte I_THD1, I_THD2 können fest vorgegeben sein, sie können jedoch auch beispielsweise abhängig sein von zuletzt erfassten zweiten Stromwerten I_W2. Die zweiten Stromwerte I_W2 repräsentieren den tatsächlich durch den Strommesswiderstand 24 fließenden Strom wesentlich präziser, was im Folgenden noch näher erläutert wird.

Ist die Bedingung des Schrittes S10 nicht erfüllt, so wird die Bearbeitung erneut, gegebenenfalls nach der vorgegebenen Wartezeitdauer in dem Schritt S2 fortgesetzt. Ist die Bedingung des Schrittes S10 hingegen erfüllt, so wird in einem Schritt S14 die Bearbeitung fortgesetzt, der weiter unten näher erläutert ist.

Quasi parallel zu den Schritten S6 bis S10 erfolgt die Bearbeitung der Schritte S12 und der folgenden Schritte. In dem Schritt S12 wird geprüft, ob seit dem letzten Bearbeiten eines Schrittes S14 ein vorgegebener zweiter Zeitabstand TA2 liegt. Ist dies nicht der Fall, so wird, gegebenenfalls nach der vorgegebenen Wartezeitdauer, die Bearbeitung erneut in dem Schritt S2 fortgesetzt. Ist die Bedingung des Schrittes S12 hingegen erfüllt, so wird in einem Schritt S14 der Mikroprozessor 4 in seinen Anschaltzustand PU_4 versetzt.

In einem anschließenden Schritt S16 werden zweite Stromwerte I_W2 für eine vorgegebene zweite Zeitdauer TD2 erfasst. Der zweite Zeitabstand TA2 kann beispielsweise in etwa 20 Minuten betragen. Die zweite Zeitdauer TA2 kann beispielsweise so gewählt werden, dass insgesamt in etwa 1000 zweite Stromwerte I_W2 erfasst werden. Die zweite Zeitdauer TD2 beträgt beispielsweise 250 ms. Typischerweise hat die Auswerteeinheit 3 nicht die Speicherkapazität, um alle zweiten Stromwerte I_W2 zwischenzuspeichern und deshalb werden sie von der Auswerteeinheit 3 dem Mikroprozessor 4 zugeleitet, der dann die zweiten Stromwerte I_W2 entsprechend digital filtert, z.B. mittelt. Aufgrund der Vielzahl der so ermittelten zweiten Stromwerte I_W2 und deren Filterung spielt bei den so gefilterten und dann auch der weiteren Verarbeitung zugrunde gelegten zweiten Strommesswerten I_W2 ein Gauß'sches Rauschen der ursprünglich erfassten zweiten Stromwerte I_W2 nur eine untergeordnete Rolle und beeinflusst deren Güte im Hinblick auf den tatsächlichen durch den Strommesswiderstand 24 fließenden Strom nur gering.

In einem Schritt S18 wird ein Integralwert I_I des Stroms durch Integrieren der zweiten Stromwerte I_W2 ermittelt, die jeweils bevorzugt der gemittelte Wert der zweiten Stromwerte I_W2 sind. Das Ermitteln des Integralwerts I_I kann besonders einfach durch Addition eines Produkts aus dem gemittelten Wert der zweiten Stromwerte I_W2 und einer Zeitdauer, die dem zweiten Zeitabstand TA2 entspricht, und addieren des bisher vorliegenden Integralwertes I_I erfolgen.

Anschließend wird in einem Schritt S20 geprüft, ob der Integralwert I_I des Stroms größer ist als ein Integralschwellenwert I_I_THD. Ist dies nicht der Fall, so wird die Bearbeitung, gegebenenfalls nach der vorgegebenen Wartezeitdauer, in dem Schritt S2 fortgesetzt. Ist die Bedingung des Schrittes S20 hingegen erfüllt, so ist dies bei geeigneter Wahl des Integralschwellenwertes I_I_THD ein Anzeichen dafür, dass der Batterie 2 eine derart große Ladung während der Ruhephase RP entnommen wurde, dass die Gefahr besteht, dass eine vorgegebene Mindestladung der Batterie 2 unterschritten werden könnte.

Ist die Bedingung des Schrittes S20 erfüllt, so wird in einem Schritt S22 ein Wecksignal S_WU erzeugt und über die Schnittstelle des Mikroprozessors 6 an das übergeordnete Steuergerät 6 weitergeleitet. Das übergeordnete Steuergerät 6 wird abhängig von dem Wecksignal S_WU aus seinem Abschaltzustand PD_6 in seinen Anschaltzustand versetzt. Befindet sich dann das übergeordnete Steuergerät 6 in seinem Anschaltzustand, werden entsprechende Daten von dem Mikroprozessor 4, wie beispielsweise der Integralwert I_I des Stroms oder auch die zweiten Stromwerte I_W2 an das übergeordnete Steuergerät 6 übertragen. Das übergeordnete Steuergerät 6 veranlasst dann abhängig von den zweiten Strommesswerten I_W2 oder auch direkt abhängig von dem Integralwert I_I des Stroms und gegebenenfalls weiteren Betriebsparametern der Batterie 2, die dann im Folgenden auf Befehle des übergeordneten Steuergeräts 6 hin in dem Batteriesensor erfasst und ermittelt werden, entsprechende Maßnahmen für eine Ladungserhaltung der Batterie. Diese Maßnahmen können beispielsweise in einer Abschaltung von Verbrauchern bestehen, die sich auch während der Ruhephasen RP regelmäßig in einem eingeschalteten Zustand befinden.

Im Anschluss an den Schritt S22 wird die Bearbeitung erneut in dem Schritt S2, gegebenenfalls nach der vorgegebenen Wartezeitdauer fortgesetzt.

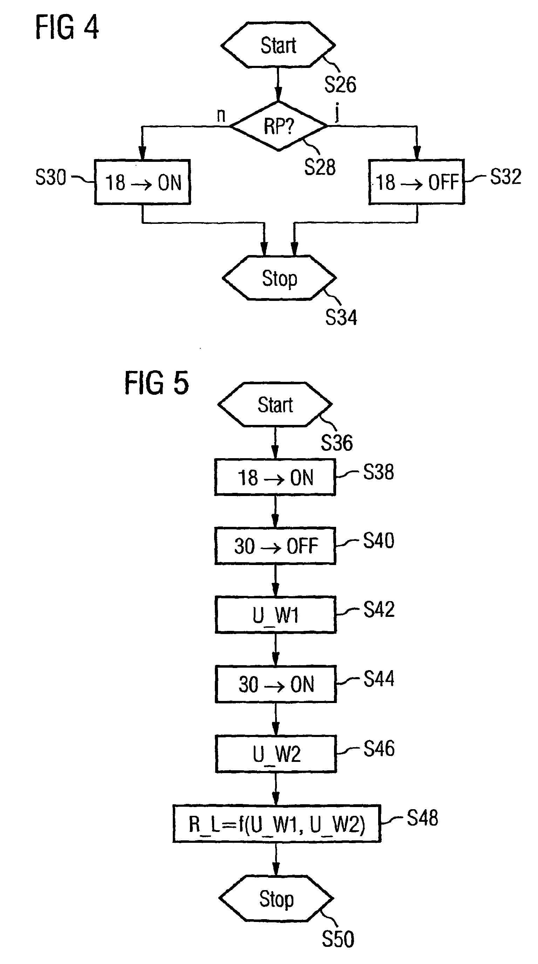

Ein weiteres Programm wird in einem Schritt S26 gestartet (Figur 4). In einem Schritt S28 wird geprüft, ob die Ruhephase RP vorliegt. Ist dies nicht der Fall, so wird der erste Schalter 18 eingeschaltet (ON), d.h. ein Stromfluss durch die ersten und zweiten Widerstände 14 und 16 ermöglicht. Dies wiederum ermöglicht ein Messen der Spannung, die an der Batterie 2 abfällt.

Ist die Bedingung des Schrittes S28 hingegen erfüllt, d.h. es liegt die Ruhephase RP vor, so wird in einem Schritt S32 der erste Schalter ausgeschaltet (OFF), d.h. ein Stromfluss durch die ersten und zweiten Widerstände 14, 16 unterbunden. Auf diese Weise wird sichergestellt, dass während der Ruhephase RP kein Strom durch die ersten und zweiten Widerstände fließt und somit eine geringere Entladung der Batterie 2 erfolgt. Gegebenenfalls kann jedoch auch außerhalb der Ruhephase RP zeitweise der erste Schalter 18 ausgeschaltet (OFF) sein.

Ein weiteres Programm wird in einem Schritt S36 gestartet. In einem Schritt S38 wird der erste Schalter 18 eingeschaltet (ON). In einem Schritt S40 wird der zweite Schalter 30 ausgeschaltet (OFF). In einem Schritt S42 wird dann ein erster Spannungswert U_W1 erfasst. Anschließend wird in einem Schritt S44 der zweite Schalter 30 angeschaltet (ON). Dies hat dann zur Folge, dass die an dem Pluspol der Batterie 2 anliegende Spannung einen Stromfluss durch den dritten Widerstand 28 bewirkt. Da der Widerstand 28 niederohmig ist, fließt nun ein deutlich erhöhter Strom von dem Pluspol der Batterie 2 hin zu dem Eingang 15 des Stromsensors als wenn ein Stromfluss durch den dritten Widerstand 28 unterbunden ist. Der erhöhte Strom hat somit zur Folge, dass ein Spannungsabfall zwischen dem Pluspol der Batterie und dem Eingang 15 des Stromsensors abhängig von dem Leitungswiderstand R_L zwischen dem Pluspol der Batterie 2 und dem Eingang 15 des Stromsensors messbar vergrößert ist.

In einem Schritt S46 wird dann anschließend ein zweiter Spannungswert U_W2 an dem ersten Eingang 20 der Auswerteeinheit 3 mittels des AD-Wandlers analog/digital gewandelt.

In einem Schritt S48, der bevorzugt in dem Mikroprozessor 4 durchgeführt wird, wird anschließend der Leitungswiderstand R_L abhängig von den erfassten ersten und zweiten Spannungswerten U_W1, U_W2 und bevorzugt abhängig von den Widerstandswerten der ersten und zweiten Widerstände 14, 16 ermittelt. Abhängig von dem Leitungswiderstand R_L kann dann für folgende Messungen der Spannung ausgangsseitig des Spannungsteilers eine entsprechende Korrektur erfolgen, um so einen präziseren Wert der Spannung zu ermitteln, die über der Batterie 2 abfällt.

Das Verfahren wird anschließend in einem Schritt S50 beendet und bevorzugt zyklisch erneut aufgerufen. Die Schritte S38 bis S42 können auch zeitlich nach den Schritten S44 bis S46 abgearbeitet werden.

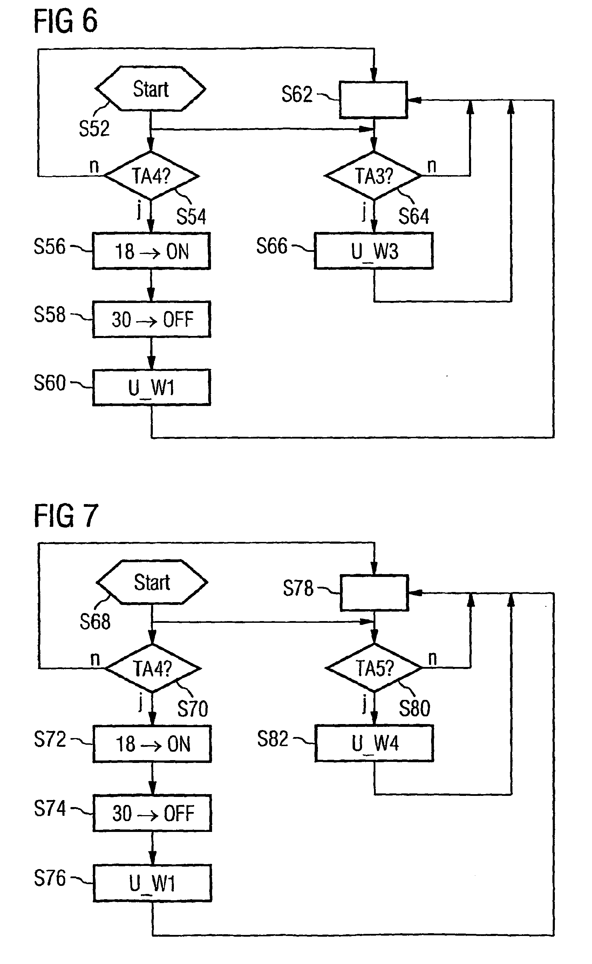

Ein weiteres Programm wird in einem Schritt S52 gestartet (Figur 6). In einem Schritt S54 wird geprüft, ob der Zeitabstand seit dem letztmaligen Bearbeiten eines Schrittes S56 gleich ist einem vierten Zeitabstand TA4. Ist dies nicht der Fall, so wird die Bearbeitung in einem Schritt S62 fortgesetzt, in dem das Programm bevorzugt für die vorgegebene Wartezeitdauer verharrt. Ist die Bedingung des Schrittes S54 hingegen erfüllt, so wird in einem Schritt S56 der erste Schalter 18 eingeschaltet (ON). In einem Schritt S58 wird der zweite Schalter 30 ausgeschaltet (OFF). In einem Schritt S60 wird der erste Spannungswert U_W1 an dem ersten Eingang 20 der Auswerteeinheit erfasst. Der erste Spannungswert U_W1 wird dann zur weiteren Verarbeitung dem Mikroprozessor 4 zur Verfügung gestellt.

Quasi parallel zu den Schritten S54 bis S60 wird die Bedingung des Schrittes S64 geprüft. In dem Schritt S64 wird geprüft, ob seit dem letztmaligen Bearbeiten eines Schrittes S66 ein Zeitabstand liegt, der einem dritten Zeitabstand TA3 entspricht. Ist dies nicht der Fall, so wird die Bearbeitung in dem Schritt S62 fortgesetzt. Ist dies jedoch der Fall, so wird in einem Schritt S66 ein dritter Spannungswert U_M3 erfasst und zwar durch Auswerten der an dem vierten Eingang 42 anliegenden Spannung. Der dritte Spannungswert U_W3 repräsentiert die an der ersten Batterie 2a abfallende Spannung. Der dritte Zeitabstand TA3 ist deutlich kleiner gewählt, bevorzugt mindestens eine Größenordnung kleiner, als der vierte Zeitabstand TA4. Auf diese Weise ist insbesondere der Analog-Digital-Wandler der Auswerteeinheit entlastet und es kann dennoch gewährleistet werden, dass unterschiedliche Ladezustände der ersten und zweiten Batterie 2a, 2b erkannt werden.

In dem Schritt S62 wird das Programm bevorzugt unterbrochen und während der Wartezeitdauer des Schrittes S62 andere Programme abgearbeitet. Im Anschluss an den Schritt S62 wird die Bearbeitung dann wieder quasi parallel in den Schritten S54 und S64 aufgenommen.

Das Programm gemäß Figur 7 wird ausgeführt bei der ersten Ausführungsform des Batteriesensors. Die Schritte S68, S70, S72, S74, S76 und S78 entsprechen den Schritten S52, S54, S56, S58, S60, S62. Quasi parallel zu dem Schritt S70 wird in einem Schritt S80 geprüft, ob seit dem letztmaligen Bearbeiten eines Schrittes S82 der Zeitabstand gleich ist einem fünften Zeitabstand TA5. Ist dies nicht der Fall, so wird die Bearbeitung in dem Schritt S78 fortgesetzt. Ist dies hingegen der Fall, so wird in dem schritt S82 ein vierter Spannungswert U_W4 erfasst, der die Spannung repräsentiert, die an dem Generator 34 abfällt. Der fünfte Zeitabstand TA5 ist bevorzugt deutlich größer gewählt, insbesondere mindestens eine Größenordnung, als der vierte Zeitabstand TA4.

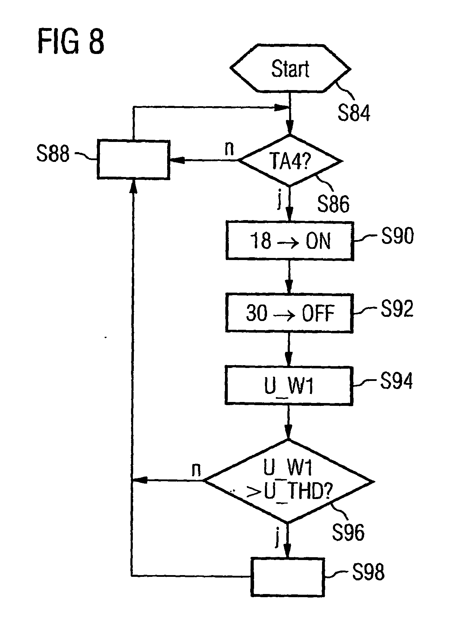

Ein weiteres Programm wird in einem Schritt S84 gestartet (Figur 8). In einem Schritt S86 wird geprüft, ob seit dem letztmaligen Bearbeiten eines Schrittes S86 der Zeitabstand gleich ist dem vierten Zeitabstand TA4. Ist dies nicht der Fall, so wird die Bearbeitung in einem Schritt S88 fortgesetzt, in dem das Programm für die vorgegebene Wartezeitdauer verharrt, bevor erneut die Bedingung des Schrittes S86 geprüft wird. Ist die Bedingung des Schrittes S86 hingegen erfüllt, so wird in einem Schritt S90 der erste Schalter eingeschaltet (ON). In einem Schritt S92 wird der zweite Schalter ausgeschaltet (OFF). In einem Schritt S94 wird der erste Spannungswert U_W1 erfasst.

In einem Schritt S96 wird anschließend geprüft, ob der erste Spannungswert U_W1 einen vorgegebenen Spannungsschwellenwert U_THD unterschreitet. Der Spannungsschwellenwert U_THD ist vorteilhaft so gewählt, dass bei seinem Unterschreiten ein weiterer Betrieb der Auswerteeinheit 3, des Mikroprozessors 4 und/oder des übergeordneten Steuergeräts 6 nicht mehr oder nur eingeschränkt möglich ist. Wesentlich ist, dass der Spannungsschwellenwert U_THD und der vierte Zeitabstand TA4 so gewählt werden, dass beim Erfülltsein der Bedingung des Schrittes S96 die Auswerteeinheit 3 und/oder der Mikroprozessor 4 noch für eine vorgebbare Zeitdauer betriebsbereit sind, die ausreicht, um in einem dann abzuarbeitenden Schritt S98 noch vorgegebene Betriebsparameter der Batterie 2 oder der Batterien 2a, 2b zu erfassen und in einem nichtflüchtigen Speicher, so z.B. ein EEPROM, abzuspeichern. Diese Betriebsparameter können dann, wenn der Mikroprozessor 4 oder das übergeordnete Steuergerät wieder betriebsbereit sind, ausgelesen werden und geeignet ausgewertet werden.

## Patentansprüche

1. Verfahren zum Betreiben eines Batteriesensors (1), der einen Strommesser zum Erfassen des Stroms der Batterie, eine Auswerteeinheit (3) und einen Mikroprozessor (4) umfasst, wobei, bei dem Verfahren während einer Ruhephase (RP) elektrische Hauptverbraucher (8, 10, 12), die einer Batterie (2) zugeordnet sind, abgeschaltet sind, **dadurch gekennzeichnet, dass**
- der Mikroprozessor (4) in einen abgeschalteten Zustand gesteuert wird,
- in vorgegebenen ersten Zeitabständen (TA1) durch die Auswerteeinheit (3) das Messsignal des Strommessers für eine vorgegebene erste Zeitdauer (TD1) erfasst wird und diesem erste Stromwerte (I_W1) zugeordnet werden, die in der Auswerteeinheit auf das Überschreiten eines ersten Stromschwellenwertes (I_THD1) und/oder das Unterschreiten eines zweiten Stromschwellenwertes (I_THD2) überwacht werden,
- bei einem Überschreiten bzw. Unterschreiten der Stromschwellenwerte (I_THD1, I_THD2) der Mikroprozessor (4) in einen eingeschalteten Zustand versetzt wird und für eine vorgegebene zweite Zeitdauer (TD2) das Messsignal des Strommessers durch die Auswerteeinheit (3) erfasst wird und ihm zweite Stromwerte (I_W2) zugeordnet werden, die dann in dem Mikroprozessor (4) ausgewertet werden,
- vorgegebene Maßnahmen zum Erhalten der elektrischen Ladung der Batterie (2) durch den Mikroprozessor (4) veranlasst werden, wenn eine vorgegebene Bedingung erfüllt ist, die abhängt von den zweiten Stromwerten (I_W2) und
- wobei die erste Zeitdauer (TD1) kleiner ist als die zweite Zeitdauer (TD2).

2. Verfahren nach Anspruch 1,
bei dem während der Ruhephase (RP) in vorgegebenen zweiten Zeitabständen (TA2) der Mikroprozessor (4) in den eingeschalteten Zustand versetzt wird und für die zweite vorgegebene Zeitdauer (TD2) das Messsignal des Strommessers in der Auswerteeinheit (3) erfasst wird und diesem zweite Stromwerte und diesem zweite Stromwerte (I_W2) zugeordnet werden, die dann in dem Mikroprozessor (4) ausgewertet werden, wobei die zweiten Zeitabstände (TA2) größer sind als die ersten Zeitabstände (TA1).

3. Verfahren nach einem der vorstehenden Ansprüche,
bei dem ein Integral des Stroms über die Zeitdauer der Ruhephase (RP) abhängig von den jeweiligen zweiten Stromwerten (I_W2) ermittelt wird.

4. Verfahren nach Anspruch 3,
bei dem ein Wecksignal (S_WU) für ein übergeordnetes Steuergerät (6) erzeugt wird, das Maßnahmen für eine Ladungserhaltung der Batterie (2) durchführen kann, wenn das Integral des Stroms einen vorgegebenen Integral-Schwellenwert (I_I_THD) überschreitet.

5. Verfahren nach einem der vorstehenden Ansprüche,
bei dem der Batteriesensor (1) einen Spannungsteiler umfasst, der eingangsseitig mit der an der Batterie (2) abfallenden Spannung beaufschlagt ist, der ausgangsseitig mit einem Eingang (20) der Auswerteeinheit (3) elektrisch leitend verbunden ist, wobei elektrisch in Serie zu dem Spannungsteiler ein erster Schalter (18) angeordnet ist, der in einer Schaltstellung einen Stromfluss durch den Spannungsteiler unterbindet und in einer anderen Schaltstellung den Stromfluss durch den Spannungsteiler ermöglicht, wobei der erste Schalter (18) in der Ruhephase (RP) in die Schaltstellung gesteuert wird, in der er den Stromfluss durch den Spannungsteiler unterbindet.

6. Verfahren nach Anspruch 5,
bei dem elektrisch parallel zu dem Spannungsteiler ein niederohmiger Widerstand angeordnet ist, zu dem elektrisch in Serie ein zweiter Schalter (30) angeordnet ist, der in einer Schaltstellung einen Stromfluss durch den niederohmigen Widerstand unterbindet und in einer anderen Schaltstellung den Stromfluss durch den niederohmigen Widerstand ermöglicht, bei dem
- der zweite Schalter (30) in die Schaltstellung gebracht wird, in der er den Stromfluss durch den Spannungsteiler unterbindet und die ausgangsseitige Spannung des Spannungsteilers als erster Spannungswert (U_W1) erfasst wird,
- der zweite Schalter (30) in die Schaltstellung gebracht wird, in der er den Stromfluss durch den Spannungsteiler ermöglicht, und die ausgangsseitige Spannung des Spannungsteilers als zweiter Spannungswert (U_W2) erfasst wird und
- abhängig von den ersten und zweiten Spannungswerten ein Leitungswiderstand (R_L) einer elektrisch leitenden Verbindung zwischen der Batterie und dem Spannungsteiler ermittelt wird.

7. Verfahren nach einem der vorstehenden Ansprüche, bei dem die Batterie mindestens eine erste und eine zweite Batterie (2a, 2b) umfasst, die elektrisch in Serie angeordnet sind und der Batteriesensor einen Spannungsmesser umfasst, dessen Messsignal charakteristisch ist für die Spannung, die entweder an der ersten oder zweiten Batterie abfällt, wobei Messwerte des Spannungsmessers in vorgegebenen dritten Zeitabständen (TA3) erfasst werden und Messwerte der Ausgangsspannung des Spannungsteilers in vorgegebenen vierten Zeitabständen (TA4) erfasst werden, wobei die dritten Zeitabstände (TA3) größer sind als die vierten Zeitabstände (TA4).

8. Verfahren nach einem der vorstehenden Ansprüche,
bei dem der Batterie (2) ein Generator (34) elektrisch parallel zugeordnet ist und ein weiterer Spannungsmesser in dem Batteriesensor (1) vorgesehen ist, dessen Messsignal charakteristisch ist für die Spannung, die an dem Generator (34) abfällt, wobei Messwerte des weiteren Spannungsmessers in vorgegebenen fünften Zeitabständen (TA5) erfasst werden und Messwerte der Ausgangsspannung des Spannungsteilers in vorgegebenen vierten Zeitabständen (TA4) erfasst werden, wobei die fünften Zeitabstände (TA5) größer sind als die vierten Zeitabstände (TA4) .

9. Verfahren nach einem der vorstehenden Ansprüche,
bei dem bei einem Unterschreiten eines vorgegebenen Spannungsschwellenwertes (U_THD) vorgegebene Betriebsparameter der Batterie (2) erfasst werden und nichtflüchtig gespeichert werden.

10. Batteriesensor, der einen Strommesser zum Erfassen des Stroms der Batterie, eine Auswerteeinheit (3) und einen Mikroprozessor (4) umfasst und der dazu ausgebildet ist, dass während einer Ruhephase (RP) elektrische Hauptverbraucher (8, 10, 12), die einer Batterie (2) zugeordnet sind, abgeschaltet sind, **dadurch gekennzeichnet, dass**
- der Mikroprozessor (4) in einen abgeschalteten Zustand gesteuert wird,
- in vorgegebenen ersten Zeitabständen (TA1) durch die Auswerteeinheit (3) das Messsignal des Strommessers für eine vorgegebene erste Zeitdauer (TD1) erfasst wird und diesem erste Stromwerte (I_W1) zugeordnet werden, die in der Auswerteeinheit auf das Überschreiten eines ersten Stromschwellenwertes (I_THD1) und/oder das Unterschreiten eines zweiten Stromschwellenwertes (I_THD2) überwacht werden,
- bei einem Überschreiten bzw. Unterschreiten der Stromschwellenwerte (I_THD1, I_THD2) der Mikroprozessor (4) in einen eingeschalteten Zustand versetzt wird und für eine vorgegebene zweite Zeitdauer (TD2) das Messsignal des Strommessers durch die Auswerteeinheit (3) erfasst wird und ihm zweite Stromwerte (I_W2) zugeordnet werden, die dann in dem Mikroprozessor (4) ausgewertet werden,
- vorgegebene Maßnahmen zum Erhalten der elektrischen Ladung der Batterie (2) durch den Mikroprozessor (4) veranlasst werden, wenn eine vorgegebene Bedingung erfüllt ist, die abhängt von den zweiten Stromwerten (I_W2) und
- wobei die erste Zeitdauer (TD1) kleiner ist als die zweite Zeitdauer (TD2) .

11. Batteriesensor nach Anspruch 10,
der einen Spannungsteiler umfasst, der eingangsseitig mit der an der Batterie (2) abfallenden Spannung beaufschlagbar ist und der ausgangsseitig mit einem Eingang (20) der Auswerteeinheit (3) elektrisch leitend verbunden ist, wobei elektrisch in Serie zu dem Spannungsteiler ein erster Schalter (18) angeordnet ist, der in einer Schaltstellung einen Stromfluss durch den Spannungsteiler unterbindet und in einer anderen Schaltstellung den Stromfluss durch den Spannungsteiler ermöglicht.

12. Batteriesensor nach Anspruch 11,
bei dem elektrisch parallel zu dem Spannungsteiler ein niederohmiger Widerstand angeordnet ist, zu dem elektrisch in Serie ein zweiter Schalter (30) angeordnet ist, der in einer Schaltstellung einen Stromfluss durch den niederohmigen Widerstand unterbindet und mit einer anderen Schaltstellung den Stromfluss durch den niederohmigen Widerstand ermöglicht.

13. Batteriesensor nach einem der vorstehenden Ansprüche,
bei dem die Batterie (2) mindestens eine erste und eine zweite Batterie (2a, 2b) umfasst, die elektrisch in Serie angeordnet sind und ein Spannungsmesser (40) zum Erfassen der Spannung, die entweder an der ersten oder zweiten Batterie (2a, 2b) abfällt, vorgesehen ist.

14. Batteriesensor nach einem der vorstehenden Ansprüche,
bei dem der Batterie ein Generator (34) elektrisch parallel zugeordnet ist und ein weiterer Spannungsmesser (36) zum Erfassen der Spannung vorgesehen ist, die an dem Generator (34) abfällt.

## Claims

1. Method for the operation of a battery sensor (1), comprising an ammeter to determine the current in the battery, an evaluation unit (3) and a microprocessor (4), wherein in said method during an idle phase (RP), main electrical consumers (8, 10, 12) that are assigned to a battery (2) are switched off, **characterised in that**
- the microprocessor (4) is directed into a switched-off state,
- at given first time intervals (TA1), the test signal from the ammeter for a given first time duration (TD1) is determined by the evaluation unit (3) and first current values (I_W1) are assigned thereto, the values being monitored in the evaluation unit to check whether a first threshold current (I_THD1) has been exceeded and/or whether a second threshold current (I_THD2) has been undershot,
- when the threshold current values (I_THD1, I_THD2) have been exceeded or undershot, the microprocessor (4) is moved into a switched-on state and for a given second time duration (TD2), the test signal from the ammeter is determined by the evaluation unit (3) and second current values (I_W2) are assigned thereto, the values then being evaluated in the microprocessor (4),
- given procedures for maintaining the electric charge in the battery (2) are initiated by the microprocessor (4) if a given condition is met, said condition depending on the second current values (I_W2) and
- the first time duration (TD1) being shorter than the second time duration (TD2).

2. Method according to claim 1, wherein
during the idle phase (RP), the microprocessor (4) is moved into the switched-on state in given second time intervals (TA2) and for the second given time duration (TD2), the test signal from the ammeter is determined in the evaluation unit (3) and second current values (I_W2) are assigned thereto, the values then being evaluated in the microprocessor (4), the second time intervals (TA2) being greater than the first time intervals (TA1).

3. Method according to any of the preceding claims, wherein an integral for the current over the time duration of the idle phase (RP) is determined as a function of the respective second current values (I_W2).

4. Method according to claim 1, wherein
a wake-up signal (S_WU) is generated for a superordinate control unit (6), which is able to implement procedures to maintain the charge in the battery (2) if the integral for the current exceeds a given integral threshold (I_I_THD).

5. Method according to any of the preceding claims, wherein the battery sensor (1) comprises a voltage divider which, on the input side, is supplied with the voltage discharged on the battery (2), and on the output side, is conductively connected to an input (20) on the evaluation unit (3), a first switch (18) being arranged electrically in series with the voltage divider. In one switch position, the aforementioned switch shuts off the flow of current through the voltage divider and, in another switch position, it enables the flow of current through the voltage divider, the first switch (18) being directed during the idle phase (RP) into the switch position in which it shuts off the flow of current through the voltage divider.

6. Method according to claim 5, wherein
a low power resistor is arranged electrically in parallel with the voltage divider, electrically in series to which a second switch (30) is arranged, which in one switch position shuts off a flow of current through the low power resistor and, in another switch position, enables the flow of current through the low power resistor, wherein
- the second switch (30) is directed into the switch position in which it shuts off the flow of current through the voltage divider and the voltage on the output side of the voltage divider is determined as the first voltage value (U_W1),
- the second switch (30) is directed into the switch position in which it enables the flow of current through the voltage divider and the voltage on the output side of the voltage divider is determined as a second voltage value (U_W2) and
- as a function of the first and the second voltage values, a line resistance (R_L) of an electrically conductive connection is determined between the battery and the voltage divider.

7. Method according to any of the preceding claims, wherein the battery comprises at least a first and a second battery (2a, 2b), which are electrically arranged in series and the battery sensor has a voltmeter, the measuring signal of which is characteristic of the voltage discharged either on the first or the second battery, measurement values on the voltmeter being determined at given third time intervals (TA3) and measurement values for the output voltage of the voltage divider being determined at given fourth time intervals (TA4). The third time intervals (TA3) are greater than the fourth time intervals (TA4).

8. Method according to any of the preceding claims, wherein a generator (34) is assigned to the battery (2) electrically in parallel therewith and a further voltmeter is provided in the battery sensor (1), the measuring signal of which is characteristic of the voltage discharged on the generator (34), measured values from the further voltmeter being determined at given fifth time intervals (TA5) and measured values for the output voltage of the voltage divider being determined at given fourth time intervals (TA4). The fifth time intervals (TA5) are greater than the fourth time intervals (TA4).

9. Method according to any of the preceding claims, wherein when the voltage drops below a given threshold voltage (U_THD), given operating parameters of the battery (2) are determined and stored in a non-volatile manner.

10. Battery sensor, comprising an ammeter to determine the current in the battery, an evaluation unit (3) and a microprocessor (4) and which is designed so that, during an idle phase (RP), main electrical consumers (8, 10, 12) assigned to a battery (2) are switched off, **characterised in that**
- the microprocessor (4) is directed into a switched-off state,
- at given first time intervals (TA1), the test signal from the ammeter for a given first time duration (TD1) is determined by the evaluation unit (3) and first current values (I_W1) are assigned thereto, the values being monitored in the evaluation unit to check whether a first threshold current value (I_THD1) has been exceeded and/or whether the current has dropped below a second threshold current value (I_THD2),
- when the current has exceeded or dropped below the threshold current values (I_THD1, I_THD2), the microprocessor (4) is moved into a switched-on state and for a given second time duration (TD2), the test signal from the ammeter is determined by the evaluation unit (3) and second current values (I_W2) are assigned thereto, the values then being evaluated in the microprocessor (4),
- given procedures for maintaining the electric charge in the battery (2) are initiated by the microprocessor (4) if a given condition is met, said condition depending on the second current values (I_W2) and
- the first time duration (TD1) being shorter than the second time duration (TD2).

11. Battery sensor according to claim 10, comprising
a voltage divider which, on the input side, is supplied with the voltage discharged on the battery (2), and on the output side, is conductively connected to an input (20) on the evaluation unit (3), a first switch (18) being arranged electrically in series with the voltage divider. In one switch position, the aforementioned switch shuts off the flow of current through the voltage divider and in another switch position it enables the flow of current through the voltage divider.

12. Battery sensor according to claim 11, wherein
a low power resistor is arranged electrically in parallel with the voltage divider, electrically in series to which a second switch (30) is arranged, which in one switch position, shuts off a flow of current through the low power resistor and, in another switch position, enables the flow of current through the low power resistor.

13. Battery sensor according to any of the preceding claims, wherein
the battery (2) comprises at least a first and a second battery (2a, 2b), which are electrically arranged in series and a voltmeter (40) to determine the voltage discharged either on the first or second battery (2a, 2b).

14. Battery sensor according to any of the preceding claims, wherein
a generator (34) is assigned to the battery electrically in parallel therewith and a further voltmeter (36) is provided to determine the voltage discharged on the generator (34).

## Revendications

1. Procédé d'utilisation d'un capteur de batterie (1) qui présente un dispositif de mesure de courant qui détecte le courant de la batterie, une unité d'évaluation (3) et un microprocesseur (4), lors du procédé, pendant une phase de repos (RP), des consommateurs électriques principaux (8, 10, 12) associés à une batterie (2) étant débranchés, **caractérisé en ce que** pendant la phase de repos :
le microprocesseur (4) est amené à un état de débranchement,
à des premiers intervalles de temps prédéterminés (TA1), le signal de mesure du dispositif de mesure de courant est détecté par l'unité d'évaluation (3) pendant une première durée (TD1) prédéterminée et des premières valeurs de courant (I_W1) sont associées à ce signal de mesure, l'unité d'évaluation évaluant si ces valeurs de courant dépassent une première valeur de seuil de courant (I_THD1) et/ou n'atteignent pas une deuxième valeur de seuil de courant (I_THD2),
lorsque les valeurs de seuil de courant (I_THD1, I_THD2) sont dépassées ou ne sont pas atteintes, le microprocesseur (4) est placé dans un état branché et le signal de mesure du dispositif de mesure de courant est détecté par l'unité d'évaluation (3) et des deuxièmes valeurs de courant (I_W2) qui lui sont associées sont ensuite évaluées dans le microprocesseur (4),
des dispositions prédéterminées de maintien de la charge électrique de la batterie (2) sont lancées par le microprocesseur (4) lorsqu'une condition prédéterminée qui dépend des deuxièmes valeurs de courant (I_W2) est satisfaite,
la première durée (TD1) étant plus courte que la deuxième durée (TD2).

2. Procédé selon la revendication 1, dans lequel, pendant la phase de repos (RP), le microprocesseur (4) est amené à l'état branché à des deuxièmes intervalles de temps (TA2) prédéterminés, et pendant la deuxième durée prédéterminée (TD2) le signal de mesure du dispositif de mesure de courant est détecté dans l'unité d'évaluation (3) et des deuxièmes valeurs de courant (I_W2) sont associées à ce signal de mesure pour ensuite être évaluées dans le microprocesseur (4), les deuxièmes intervalles de temps (TA2) étant plus longs que les premiers intervalles de temps (TA1).

3. Procédé selon l'une des revendications précédentes, dans lequel une intégrale du courant pendant la durée de la phase de repos (RP) est déterminée sur les deuxièmes valeurs de courant (I_W2) concernées.

4. Procédé selon la revendication 3, dans lequel un signal d'activation (S_WU) est créé pour un appareil de commande (6) d'ordre hiérarchique supérieur, qui peut prendre des dispositions de maintien de la charge de la batterie (2) lorsque l'intégrale du courant dépasse une valeur de seuil prédéterminée de l'intégrale (I_I_THD).

5. Procédé selon l'une des revendications précédentes, dans lequel le capteur de batterie (1) comprend un diviseur de tension à l'entrée duquel est appliquée la tension aux bornes de la batterie (2) et dont la sortie est reliée de manière électriquement conductrice à une entrée (20), de l'unité d'évaluation (3), un premier commutateur (18) qui dans une position de commutation interrompt le passage du courant dans le diviseur de tension et dans une deuxième position de commutation permet le passage du courant dans le diviseur de tension, est raccordé électriquement en série au diviseur de tension, le premier commutateur (18) étant amené dans la position de commutation dans laquelle il interrompt le passage du courant dans le diviseur de tension pendant la phase de repos (RP).

6. Procédé selon la revendication 5, dans lequel une résistance de faible valeur à laquelle un deuxième commutateur (30) qui, dans une première position de commutation, interrompt le passage du courant dans la résistance de faible valeur et dans une autre position de commutation permet le passage du courant dans la résistance à faible valeur, est raccordé électriquement en série, est raccordée électriquement en parallèle au diviseur de tension, et dans lequel :
le deuxième commutateur (30) est placé dans la position de commutation dans laquelle il interrompt le passage du courant dans le diviseur de tension et où la tension à la sortie du diviseur de tension est détectée comme première valeur de tension (U_W1),
le deuxième commutateur (30) est amené dans la position de commutation dans laquelle il permet le passage du courant dans le diviseur de tension et dans laquelle la tension à la sortie du diviseur de tension est détectée comme deuxième valeur de tension (U_W2) et
la résistance (R_L) d'un conducteur qui relie électriquement la batterie et le diviseur de tension est déterminée en fonction de la première et de la deuxième valeur de tension.

7. Procédé selon l'une des revendications précédentes, dans lequel la batterie comprend au moins une première et une deuxième batterie (2a, 2b) qui sont raccordées électriquement en série, le capteur de batterie comprenant un dispositif de mesure de tension dont le signal de mesure est caractéristique de la tension aux bornes de la première ou de la deuxième batterie, les valeurs de mesure du dispositif de mesure de tension étant déterminées à des troisièmes intervalles de temps (TA3) prédéterminés et les valeurs de mesure de la tension à la sortie du diviseur de tension étant détectées à des quatrièmes intervalles de temps (TA4) prédéterminés, les troisièmes intervalles de temps (TA3) étant plus longs que les quatrièmes intervalles de temps (TA4).

8. Procédé selon l'une des revendications précédentes, dans lequel une génératrice (34) est raccordée électriquement en parallèle à la batterie (2) et dans lequel un autre dispositif de mesure de tension dont le signal de mesure est caractéristique de la tension aux bornes de la génératrice (34) est prévu dans le capteur de batterie (1), les valeurs de mesure de l'autre dispositif de mesure de tension étant détectées à des cinquièmes intervalles de temps (TA5) prédéterminés et les valeurs de mesure de la tension de sortie des diviseurs de tension étant détectées à des quatrièmes intervalles de temps (TA4) prédéterminés, les cinquièmes intervalles de temps (TA5) étant plus longs que les quatrièmes intervalles de temps (TA4).

9. Procédé selon l'une des revendications précédentes, dans lequel, lorsqu'une valeur de seuil de tension (U_THO) prédéterminée n'est pas atteinte, des paramètres prédéterminés du fonctionnement de la batterie (2) sont détectés et sont conservés dans une mémoire non volatile.

10. Capteur de batterie qui comporte un dispositif de mesure de courant qui détecte le courant de la batterie, une unité d'évaluation (3) et un microprocesseur (4), et.configuré pour, pendant une phase de repos (RP), débrancher des consommateurs électriques principaux (8, 10, 12) associés à une batterie (2), **caractérisé en ce que**:
le microprocesseur (4) est amené à un état de débranchement,
à des premiers intervalles de temps prédéterminés (TA1), le signal de mesure du dispositif de mesure de courant est détecté par l'unité d'évaluation (3) pendant une première durée (TD1) prédéterminée et des premières valeurs de courant (I_W1) sont associées à ce signal de mesure, l'unité d'évaluation évaluant si ces valeurs de courant dépassent une première valeur de seuil de courant (I_THD1) et/ou n'atteignent pas une deuxième valeur de seuil de courant (I_THD2),
lorsque les valeurs de seuil de courant (I_THD1, I_THD2) sont dépassées ou ne sont pas atteintes, le microprocesseur (4) est placé dans un état branché et le signal de mesure du dispositif de mesure de courant est détecté par l'unité d'évaluation (3) et des deuxièmes valeurs de courant (I W2) qui lui sont associées sont ensuite évaluées dans le microprocesseur (4),
des dispositions prédéterminées de maintien de la charge électrique de la batterie (2) sont lancées par le microprocesseur (4) lorsqu'une condition prédéterminée qui dépend des deuxièmes valeurs de courant (I_W2) est satisfaite,
la première durée (TD1) étant plus courte que la deuxième durée (TD2).

11. Capteur de batterie selon la revendication 10, qui comprend un diviseur de tension à l'entrée duquel la tension aux bornes de la batterie (2) peut être appliquée et dont la sortie est reliée de manière électriquement conductrice à une entrée (20) de l'unité d'évaluation (3), un premier commutateur (18) qui dans une position de commutation interrompt le passage du courant dans le diviseur de tension et dans une autre position de commutation permet le passage du courant dans le diviseur de tension est raccordé électriquement en série au diviseur de tension.

12. Capteur de batterie selon la revendication 11, dans lequel une résistance de faible valeur à laquelle un deuxième commutateur (30) qui dans une position de commutation interrompt le passage du courant dans la résistance de faible valeur et dans une autre position de commutation permet le passage du courant dans la résistance à faible valeur est raccordée électriquement en série, est raccordé électriquement en parallèle au diviseur de tension.

13. Capteur de batterie selon l'une des revendications précédentes, dans lequel la batterie (2) comprend au moins une première et une deuxième batterie (2a, 2b) qui sont raccordées électriquement en série et un dispositif (40) de mesure de tension qui détecte la tension aux bornes de la première ou de la deuxième batterie (2a, 2b).

14. Capteur de batterie selon l'une des revendications précédentes, dans lequel une génératrice (34) est raccordée électriquement en parallèle à la batterie et un autre dispositif (36) de mesure de tension est prévu pour détecter la tension aux bornes de la génératrice (34).
